Europäisches Patentamt

European Patent Office

Office européen des brevets

(11) Publication number: **0 257 184 B1**

(12) **EUROPEAN PATENT SPECIFICATION**

(45) Date of publication of patent specification: **20.05.92** (51) Int. Cl.⁵: **G01R 33/14**

(21) Application number: **87104775.9**

(22) Date of filing: **31.03.87**

(54) **Non-destructive m-h hysteresis testers for magnetic computer discs.**

(30) Priority: **27.06.86 US 879670**

(43) Date of publication of application:
**02.03.88 Bulletin 88/09**

(45) Publication of the grant of the patent:
**20.05.92 Bulletin 92/21**

(84) Designated Contracting States:
**DE FR GB**

(56) References cited:
**GB-A- 1 385 198**

(73) Proprietor: **Hewlett-Packard Company
Mail Stop 20 B-O, 3000 Hanover Street
Palo Alto, California 94304(US)**

(72) Inventor: **Hesterman, Victor W.
12715 Canario Way
Los Altos California 94022(US)**

(74) Representative: **Liesegang, Roland, Dr.-Ing.
FORRESTER & BOEHMERT Franz-
Joseph-Strasse 38
W-8000 München 40(DE)**

## Description

The invention refers to an apparatus for testing a disc according to the first preamble of claim 1.

In this application, an item number's highest order digit identifies the figure. The lower order digits identify the item.

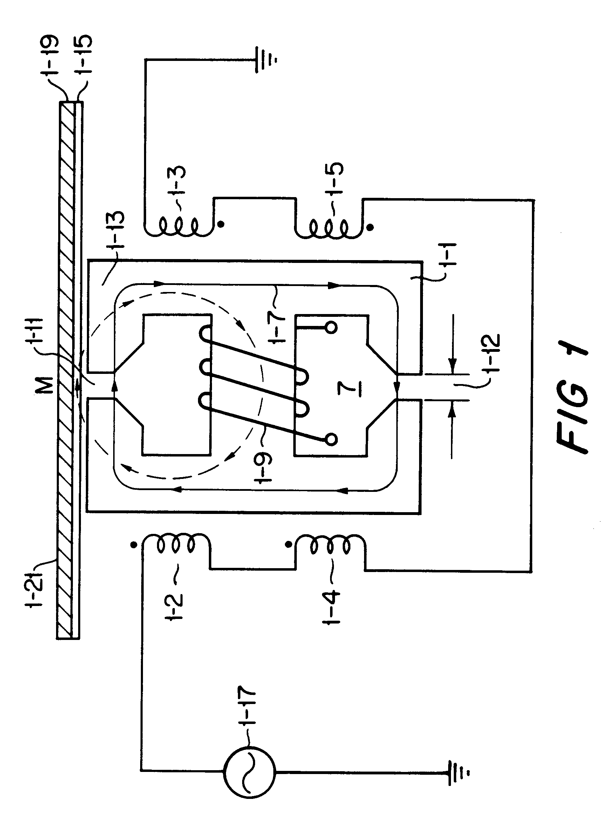

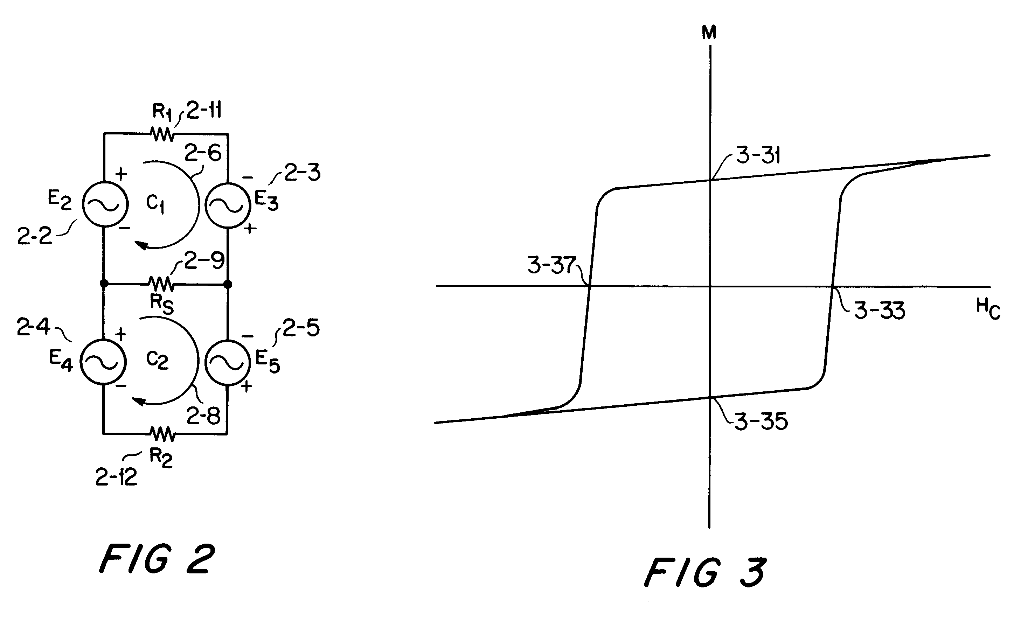

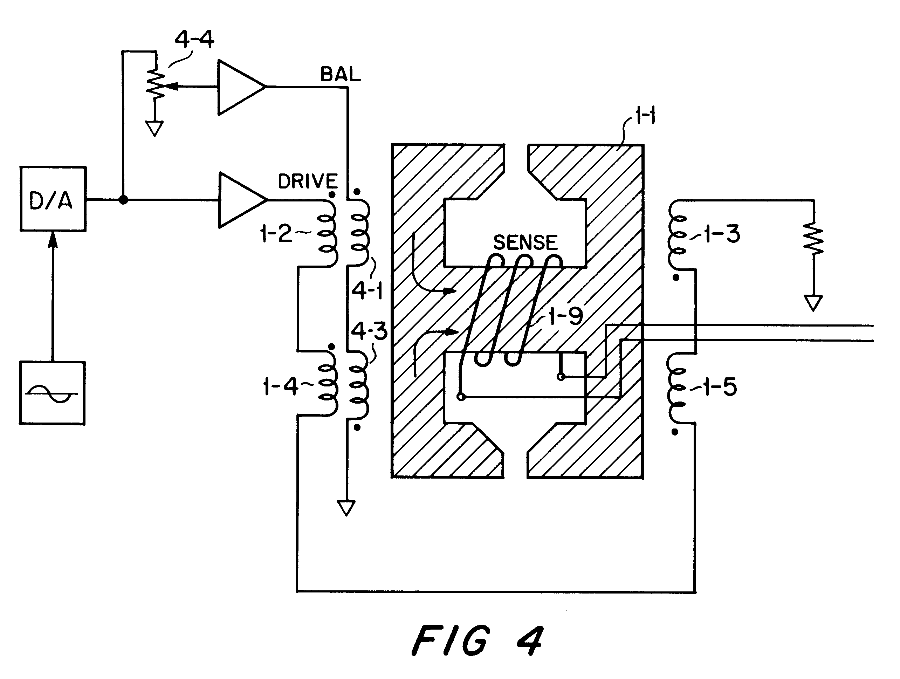

Figure 3 shows an M-H hysteresis loop of a computer disc. $H_c$ 3-33, the coercivity, represents the strength of the applied magnetic field required to switch the magnetisation, M, of the disc from a negative polarity to a positive polarity. Likewise, $H_c$ 3-37, represents the strength of the applied magnetic field where the magnetic field, M, of the disc switches from a positive polarity to a negative polarity. Thus, when writing to a disc the applied magnetic field, H, must exceed $H_c$ 3-33 to change the polarity of the magnetization from negative to positive or be less than $H_c$ 3-37 to change the polarity of the magnetic field from positive to negative. When reading the discs, the read head detects a magnetic field, M, of the disc. The magnitude of magnetic field will be $M_r$ 3-31 or $M_r$ 3-35. Thus, the M-H hysteresis loop properties of the discs must be carefully controlled in the manufacturing procedure.

The most common prior art technique for measuring the M-H hysteresis loop property of computer discs requires samples to be cut or punched from the disc. Then, a vibrating sample magnetometer measures the M-H hysteresis loop properties of the sample. This technique has several disadvantages. The cutting or punching process may distort the sample and thereby change the magnetic property being measured because of magnetostriction. Ferromagnetic contamination on the edges of the sample created by the cutting or punching process contributes additional error to measurements of the M-H hysteresis loop. Furthermore, the prior art test methods consume time. The cutting of each sample may require fifteen minutes or more. Additionally, the measurement of the H-M hysteresis loop properties in a vibrating sample magnetometer (VSM) usually requires from 20 to 40 minutes per sample. Worst of all this testing method destroys the disc so it can no longer be used for other tests.

There have been several attempts to improve the accuracy and speed of M-H hysteresis loop testers. One scheme cuts samples very carefully to minimize distortion of its magnetic properties. Another scheme uses a diamond tip or a tungsten carbide cutting edge to prevent steel or ferromagnetic material from contacting the sample and contaminating it. Another scheme reduces the number of samples tested and the time required for testing. However, reducing the number of test samples sacrifices the quality of the tests.

The disadvantages of destroying the disc are partially offset by conducting the M-H looper test last. However, if the need for further testing becomes apparent, the destruction of the disc makes their execution impossible.

The LDJ Co. of Michigan sells an M-H hysteresis loop tester that measures the M-H hysteresis loop of a large part of the disc nondestructively. This device tests large portions of the disc at once by applying a magnetic field to the entire disc. Then it measures the resulting magnetization change in a large part of the disc which includes both sides of the disc along its diameter. Testing large portions of the disc at once produces inaccurate results. Some parts of the tested region are magnetized in a circumferential direction and other parts in a radial direction. The magnetic properties may be different in these two directions. In addition, this method does not measure variations in the M-H hysteresis loop around the circumference of the disc. These measurements are necessary to test the uniformity of the manufacturing process.

Quad Group Inc. sells an M-H hysteresis loop tester that measures the M-H hysteresis loop characteristics of the surface of the magnetic film by using the Kerr effect. It cannot detect the additional magnetization below the surface of a magnetic film coating. Therefore, this M-H hysteresis loop tester cannot determine the magnetisation x thickness product, which is important to control in a manufacturing process. The other types of instruments listed above, including this invention, actually measure the magnetization x thickness product. This invention, however, cannot at its present stage of development, accurately measure the squareness, $M_s/M_r$. Although this is an important parameter, it does not typically vary much for a given manufacturing process on a day-to-day basis.

The object of the invention is to provide an apparatus which can accurately measure the M-H hysteresis loop properties of a disc without damaging the disc.

This problem is solved by claim 1.

The present invention has several advantages. It provides for an apparatus for accurately measuring the M-H hysteresis loop properties, especially $M_r$ and $H_c$, of a disc without destroying the disc. The testing of entire discs instead of samples cut from the disc eliminates inaccuracies caused by cutting. Also, the elimination of cut samples reduces the time required to measure the M-H hysteresis loop. Also, the invention permits easy and quick measurements of variations in the M-H hysteresis loop around the circumference of the disc.

The invention provides an apparatus for accurately measuring the M-H hysteresis loop properties around the circumference of a disc. The apparatus has a magnetic core and several balanced drive coils to produce a large drive magnetic field to magnetise the sample. A sense coil located in the center of the magnetic core produces a voltage signal proportional to the rate of change of magnetic flux passing through it. As shown by the equation $V = N_2 d\Phi/dt$ where $N_2$ is the number of turns in the sense winding 1-9 and $d\Phi/dt$ is the time rate of change in magnetic flux. The components of drive magnetic flux cancel each other out in the center leg of the magnetic core. Thus, the sense coil does not detect them. The symmetrical magnetic core contains two gaps with identical characteristics. The disc under test is placed adjacent to one gap. A change in magnetization of the disc changes the magnetic flux in the center leg of the magnetic core. A sense coil located on the center leg of the magnetic core detects the magnetic flux produced by the sample. The signal produced by the sense coil is given by $V = N_2 d\Phi/dt$.

The method for carrying out the measurements calibrates the apparatus so that it is not sensitive to eddy currents in the disc substrate or to imbalances in the air gaps or top and bottom parts of the core.

Figure I is an the preferred embodiment of the invention.

Figure 2 is an electrical analog equivalent circuit of the preferred embodiment of the invention shown in Figure I.

Figure 3 is an M-H hysteresis loop of a typical disc measured by the apparatus in Figure I.

Figure 4 shows the electronic balance circuitry.

Figure I shows the preferred embodiment of the invention. The magnetic core I-I and the drive coils mechanisms I-2, I-3, I-4 and I-5 form an electromagnet which produces a large drive magnetic field of about I20,000 At/M (I500 Oersteds) to magnetize the magnetic film on the disc I-I5. Note: Figure I shows the drive coil mechanism I-2, I-3, I-4, I-5 schematically. In actual practice the individual coils I-2, I-3, I-4 and I-5 are wrapped around the magnetic core I-I. The equation $H = KN_1 I$ describes the magnetic field in the gaps produced by the coils I-2, I-3, I-4 and I-5. Where K is a constant, $N_1$ is the number of turns of wire in each drive coil, and I is the current through the coils I-2, I-3, I-4 and I-5. To produce the drive magnetic field, the current in the coils I-2, I-3, I-4 and I-5 ranges from 0 to 0.5 A. The magnet core I-I is constructed from ferrite or permalloy material with a high remanent magnetization, $M_r$, low coercivity, $H_c$, and low magnetostriction. If the amp- turns, NI, of each drive coil I-2, I-3, I-4 and I-5 are identical, and the ratio of gap length/gap area is the same for each gap I-II, I-I2, and the core is symmetrical top to bottom, and if the drive coils I-2, I-3, I-4 and I-5 are placed symmetrically around the magnetic core I-I, then the large drive flux I-7 passes around the periphery of the magnet I-I and not through the sense coil I-9 as shown in Figure I. Figure 2 further illustrates this principal.

Figure 2 is an analog electrical equivalent circuit of the apparatus shown in Figure I. The ac electric generator $E_2$ 2-2 represents the amp-turns of coil I-2. Likewise, the other generators $E_3$ 2-3, $E_4$ 2-4, and $E_5$ 2-5 represent the amp-turns of coils I-3, I-4, and I-5. The resistor $R_1$ 2-II represents the magnetic reluctance of the top air gap I-II plus the reluctance of the top part of the core and the bottom resistor $R_2$ 2-I2 represents the reluctance of the bottom air gap 2-I2 plus the reluctance of the bottom part of the core. $R_s$ 2-9 represents the reluctance of the center leg of the core where the sense coil I-9 is wound. The generators 2-2, 2-3, 2-4 and 2-5 are in phase. If $E_2 = E_3 = E_4 = E_5$ and $R_1 = R_2$, the mesh current 2-6 and the mesh current 2-8 are equal. In $R_s$ 2-9, the currents 2-6 and 2-8 have the same magnitude and the opposite polarity. Therefore, they cancel out. Provided the coils I-2, I-3, I-4, and I-5 are symmetrically placed, the coils produce the same drive field, the core is symmetrical top-to-bottom, and the gaps I-II, I-I2 have the same reluctance, the magnetic flux produced by coils I-2 and I-3 will have the same magnitude as the magnetic flux produced by coils I-4 and I-5. In the sense coil I-9, the magnetic flux produced by the top two coils I-2, I-3 will have the same magnitude but opposite polarity from the magnetic flux produced by the bottom two coils I-4, I-5. Therefore, the magnetic flux from the top two coils I-2, I-3 and the magnetic flux from the bottom two coils I-4, I-5 will cancel each other out in the center leg.

A sample disc I-2I is placed near one of the two air gaps I-II of the magnet core I-I. The magnetic thin film I-I5 becomes magnetized by the drive magnetic field I-7 in the gap I-II. An unbalance in the magnetic flux through the sense coil I-9 results. The changing magnetic flux I-I3 produced by the magnetization in the magnetic thin film I-I5 of the sample disc I-2I passes through the sense coil I-9 and induces an voltage in it. This voltage is proportional to $d\Phi/dt$ $\Phi$ where equals the magnetic flux through the sensor coil I-9. The equation describing this phenomenon is:

$$V = N_2 \, d\Phi/dt.$$

3

The voltage signal produced by sense coil 1-9 is amplified with a special low noise differential amplifier, and integrated to become proportional to the total magnetic flux through the sense coil and also proportional to the magnetization, M, of the sample disc 1-21. The magnetization, M, of the sample thin film 1-15 can be derived from the voltage of the sense coil 1-9 through the following series of equations, that use the SI system of units.

$$V = N_2 \, d\Phi_2/dt$$

$$(1/N_2)\int V \, dt = \Delta\Phi_2$$

$$\Delta\Phi_1 = \int \Delta B \, dA = (\Delta B)A \, , \quad \text{if B is uniform over Area A}$$

$$\Delta B = (\Delta M + H)\mu_0$$

$$\int V \, dt = N_2 K(\Delta B)A = N_2 A \mu_0 (\Delta M + H)$$

$$M = \left(\frac{\int V \, dt}{K\mu_0 A N_2}\right) - H$$

H is the magnetic field applied to the sample disc 1-21 by the coils 1-2, 1-3, 1-4, and 1-5 and the magnetic core 1-1. The magnetization, M, of the magnetic film 1-15 results from applying the magnetic field H to the sample magnetic film 1-15, and varies according to the thin film material 1-15 used and the way it is processed in manufacture. And A is the cross section area of the center leg of the magnetic core 1-1 upon which the sense coil 1-9 is wound. A digital computer does the necessary integration and solves the equations to obtain M, the magnetization produced by the sample thin film of disc I-2l.

A digital computer controls the placement of the sample disc I-2l, subtracts out eddy currents, subtracts out errors due to unbalance of the magnetic core I-l, and plots the resulting M-H hysteresis loop.

The eddy currents in the aluminum substrate I-l9 of the sample disc I-2l produce an unwanted magnetic signal that must be eliminated. The eddy current's amplitude is proportional to the drive frequency produced by the drive coils I-2, I-3, I-4 and I-5. Therefore, drive signals I-7 frequency is only 0.5 Hz. in the preferred embodiment of the invention. Even with such a low frequency drive signal I-7, the eddy current amplitude is typically twice the amplitude of the magnetic signal from the magnetic layer I-l5 of the the sample discl-2l. The magnetic signal produced by the eddy currents in the substrate I-l9 are calibrated out of the magnetic signal I-l3 which also includes the magnetic signals from the magnetic layer I-l5 of the sample disc I-2l. The calibration procedure uses a dummy disc identical to the sample disc I-2l except that it does not have a magnetic film. The dummy disc is placed in the testing position and the resulting magnetic signal is measured. The calibration procedure subtracts the dummy disc magnetic signal from the magnetic signal I-l3 emanating from sample discs I-2l with a magnetic layer I-l5. This subtraction process also subtracts out the H term in last equation above. The dummy disc measurement is done both before and after the sample measurement and the average of the before and after signals are subtracted. This removes errors due to the linear drifting of the balance.

If the electrical resistivity of dummy disc's substrate differs from the the sample disc's substrate I-l9, then the dummy disc's eddy current signal will differ substantially from the sample disc I-2l substrate's eddy current signal. In this case, an additional procedure eliminates the eddy current's contributions to the magnetic signal I-l3 of the sample disc I-2l. This procedure reduces the amplitude of the drive signal I-7 so the peak value of the applied magnetic field, H, is well below the coercivity, $H_c$, of the magnet layer I-l5 of the sample disc I-2l. The resulting eddy current signal imbalance between the sample and the dummy is measured. A computer uses this measurement to obtain a correction term for the subsequent M-H hysteresis loop measurements.

The calibration of the M axis of the M-H hysteresis loop must include the effects of the fringing magnetic fields. These unwanted fringe fields are the magnetic fields that are not directly over the gap I-ll, but are in the near vicinity of the gap. These fringe fields are smaller than the field directly over the gap, and therefore partially switch some extra magnetization of the sample film. This contributes a small error term that must be calibrated out. The size of this error term depends upon the coercivity $H_c$ of the sample. If $H_c$ is low, then the fringe field switches more of the sample thin film I-l5. Conversely, if $H_c$ is high, the fringe field switches less of the sample. This error term can be removed by calibrating with two or more standard discs having different $H_c$ values. Then a calibrating factor that depends linearly upon $H_c$, can be determined and this factor used by the computer to plot each M, H data point on the hysteresis loop.

The successful implementation of the invention depends upon the correct choice of several design parameters. The dimensions of the air gaps I-II, I-I2 must be carefully chosen. The ratio of the length of each gap I-II, I-I2 and the cross-sectional area of the magnetic core I-I at the I5 gaps I-II, I-I2 must be very nearly equal. The imbalance of the air gaps I-II and I-I2, is described as the difference between the ratios for each gap divided by the ratio of one of the gaps:

$$\text{Imbalance} = \frac{\dfrac{\underline{\text{gap 1-11 length}}}{\underline{\text{gap 1-11 area}}} - \dfrac{\underline{\text{gap 1-12 length}}}{\underline{\text{gap 1-12 area}}}}{\dfrac{\underline{\text{gap 1-11 length}}}{\text{gap 1-12 area}}} \; 10^{-6},$$

This imbalance must be very small, roughly I part in I million or less. In order to meet these stringent requirements, a very stable clamping arrangement has been devised. The clamps have a fiberglass frame with fine adjustment screws. The screws are tightened or loosened to alter the length of the gaps I-II and I-I2.

It is also important that the top and bottom parts are made of the same block of material so the temperature will tend to be the same top-to-bottom. If two separate magnetic cores I-I are used, one for top gap I-II and one for bottom gap I-I2, there would be temperature differences between the two cores I-I. A temperature difference would introduce errors into the sense coil I-I9 readings.

The electronic balance circuitry shown in Figure 4 achieves further precision in the balance equation. The electronic balance circuitry adjusts the magnetic flux in the magnetic core I-I so that the total magnetic flux through the sense coil I-9 is very nearly zero when a sample disc I-2I is not being tested. The balance circuitry contains balance coils 4-I and 4-3. Balance coils 4-I, 4-3 are wound in opposite directions so that the magnetic flux created by these coils has the same polarity in the center arm of the magnetic core I-I upon which the sense coil I-9 is wound. The voltage of the sense coils I-9 is measured without a sample disc I-2I in place. If a voltage is detected, the signal through the balance coils 4-I and 4-3 is adjusted by means of attenuator 4-4 to eliminate the voltage at the sense coil I-9 outputs. Further precision in the balance is obtained by using the computer to subtract the remaining unbalance from the test results. Thus, the effect of the imbalance of air gaps I-II and I-I2 is corrected out, so that the imbalance of Eq. (7) is less than $I \times I0^6$.

## Claims

1. An apparatus for testing a disc (1-21) having a magnetic film (1-15) comprising
a magnetic field source (1-1, 1-2, 1-3, 1-4, 1-5); and a measuring means (1-9) for measuring the magnetization , which is induced by said magnetic field source through the entire thickness of said magnetic film, throughout a portion of said disc without damaging said disc, **characterized** in that said magnetic field source (1-1, 1-2, 1-3, 1-4, 1-5) consists of a magnetic core (1-1) and four drive coils (1-2, 1-3, 1-4, 1-5) and that said magnetic core (1-1) has two U-shaped halves connected together by a leg running between the interior of said two halves and leaving gaps (1-11, 1-12) between the opposing ends of said U-shaped halves, and that said four drive coils (1-2, 1-3, 1-4, 1-5) are wound around the four magnetic core portions of said U-shaped halves which are separated by said leg, and that a sense coil (1-9) is wrapped around said leg connecting said U-shaped core halves, the arrangement being such that the magnetic flux produced by said drive coil (1-2, 1-3, 1-4, 1-5) and said magnetic core (1-1) is substantially zero inside of said sense coil (1-9).

2. An apparatus as in claim 1, **characterized** in that said drive coils (1-2, 1-3, 1-4, 1-5) and said gaps (1-11, 1-12) are matched so that the magnetic flux generated by said drive coils (1-2, 1-3, 1-4, 1-5) has an amplitude of very nearly zero in said leg.

3. An apparatus as in claim 2, **characterized** in that said gaps (1-11, 1-12) are identical, said halves are identical, said leg connects said halves in their middle, and said four drive coils (1-2, 1-3, 1-4, 1-5) are identical.

4. An apparatus as in one of claims 1 to 3, **characterized** in that said disc (1-21) is placed adjacent to one of said gaps (1-11) to be magnitized by said magnetic field generated by said magnetic field source (1-1, 1-2, 1-3, 1-4, 1-5), said sense coil (1-9) measuring said magnetization of said disc (1-21)

5. An apparatus as in one of claims 1 to 4, **characterized** in that said magnetic core (1-1) is symmetrical about a line passing midway through the length of said leg.

6. An apparatus as in one of claims 1 to 5, **characterized** in that said gaps (1-11, 1-12) can be adjusted to make them precisely equal and to maintain that adjustment in a stable manner of long periods of time.

**Revendications**

1. Appareil d'essai d'un disque (1-21) comportant une pellicule magnétique (1-15), comprenant une source de champ magnétique (1-1, 1-2, 1-3, 1-4, 1-5); et des moyens (1-9) de mesure de l'aimantation qui est induite par ladite source de champ magnétique dans la totalité de l'épaisseur de ladite pellicule magnétique et dans une partie dudit disque sans endommager ledit disque, caractérisé en ce que ladite source de champ magnétique (1-1, 1-2, 1-3, 1-4, 1-5) consiste en un noyau magnétique(1-1) et en quatre bobines d'attaque (1-2, 1-3, 1-4, 1-5) et en ce que ledit noyau magnétique (1-1) comporte deux moitiés en U reliées l'une à l'autre par une branche placée entre les côtés intérieurs desdites deux moitiés et laissant subsister des entrefers (1-11, 1-12) entre les extrémités opposées desdites moitiés en U et en ce que lesdites quatre bobines d'attaque (1-2, 1-3, 1-4, 1-5) sont enroulées autour des quatre parties du noyau magnétique desdites moitiés en U qui sont séparées par ladite branche et en ce qu'une bobine de détection (1-9) est enroulée autour de ladite branche qui relie lesdites moitiés en U du noyau la disposition étant telle que le flux magnétique produit par lesdites bobines d'attaque (1-2, 1-3, 1-4, 1-5) et ledit noyau magnétique (1-1) soit pratiquement nul à l'intérieur de ladite bobine de détection (1-9).

2. Appareil selon la revendication 1, caractérisé en ce que lesdites bobines d'attaque (1-2, 1-3, 1-4, 1-5) et lesdits entreiers (1-11, 1-12) sont coordonnés de manière que le flux magnétique généré par lesdites bobines d'attaque (1-2, 1-3, 1-4, 1-5) ait une amplitude très proche de zéro dans ladite branche.

3. Appareil selon la revendication 2, caractérisé en ce que lesdits entrefers (1-11, 1-12) sont identiques, lesdites moitiés sont identiques, ladite branche relie lesdites moitiés en leur milieu et lesdites quatre bobines d'attaque (1-2, 1-3, 1-4, 1-5) sont identiques.

4. Appareil selon l'une des revendications 1 à 3, caractérisé en ce que ledit disque (1-21) est placé au voisinage de l'un desdits entrefers (1-11) de manière à être aimanté par ledit champ magnétique généré par ladite source de champ magnétique (1-1, 1-2, 1-3, 1-4, 1-5), ladite bobine de détection (1-9) mesurant ladite aimantation dudit disque (1-21).

5. Appareil selon l'une des revendications 1 à 4, caractéricé en ce que ledit noyau magnétique (1-1) est symétrique de part et d'autre d'une ligne passant à travers le milieu de la longueur de ladite branche.

6. Appareil selon l'une des revendications 1 à 5, caractérisé en ce que lesdits entrefers (1-11, 1-12) peuvent être réglés de manière qu'ils soient rendus égaux avec précision et qu'ils conservent ce réglage de manière stable pendant de longues périodes de temps.

**Patentansprüche**

1. Vorrichtung zum Testen einer einen Magnetfilm (1-15) aufweisenden Platte (1-21), mit
einer Magnetfeldquelle (1-1,1-2,1-3,1-4,1-5) und mit einer Meßvorrichtung (1-9) zum Messen der Magnetisierung , die von der Magnetfeldquelle durch die gesamte Dicke des Magnetfilms induziert wird, durch einen Abschnitt der Platte hindurch, ohne die Platte zu beschädigen, dadurch **gekenn-**

**zeichnet,** daß die Magnetfelquelle (1-1,1-2,1-3,1-4,1-5) aus einem Magnetkern (1-1) und vier Steuerspulen (1-2,1-3, 1-4,1-5) besteht und daß der Magnetkern (1-1) zwei U-förmige Hälften aufweist, die miteinander durch einen zwischen den Innenseiten der zwei Hälften laufenden und zwischen den gegenüberliegenden Enden der U-förmigen Hälften Zwischenräume (1-11,1-12) freilassenden Steg verbunden sind, und daß die vier Steuerspulen (1-2,1-3-1-4,1-5) um die vier durch den Steg getrennten Magnetkernabschnitte der U-förmigen Hälften gewickelt sind, und eine Sensorspule (1-9) um diesen die U-förmigen Kernhälften verbindenden Steg gewickelt ist, wobei die Vorrichtung so aufgebaut ist, daß der durch die Steuerspulen (1-2,1-3,1-4,1-5) und den Magnetkern (1-1) erzeugte magnetische Fluß im Inneren der Sensorspule (1-9) im wesentlichen Null ist.

2. Vorrichtung nach Anspruch 1, dadurch **gekennzeichnet,** daß die Steuerspulen (1-2,1-3, 1-4,1-5) und die Zwischenräume (1-11,1-12) so abgestimmt sind, daß der durch die Steuerspulen (1-2,1-3,1-4, 1-5) erzeugte magnetische Fluß in dem Steg eine Amplitude von nahezu Null aufweist.

3. Vorrichtung nach Anspruch 2, dadurch **gekennzeichnet,** daß die Zwischenräume (1-11,1-12) identisch und die Hälften identisch ausgebildet sind, der Steg die Hälften in ihrer Mitte verbindet und daß auch die vier Steuerspulen (1-2,1-3,1-4,1-5) identisch ausgebildet sind.

4. Vorrichtung nach einem der Ansprüche 1 bis 3, dadurch **gekennzeichnet,** daß die Platte (1-21) benachbart einem der Zwischenräume (1-11) angeordnet ist, um durch das von der Magnetfeldquelle (1-1,1-2, 1-3,1-4,1-5) erzeugte Magnetfeld magnetisiert zu werden, wobei die Sensorspule (1-9) die Magnetisierung der Platte (1-21) mißt.

5. Vorrichtung nach einem der Ansprüche 1 bis 4, dadurch **gekennzeichnet,** daß der Magnetkern (1-1) symmetrisch zu einer mittig längs durch den Steg gehenden Linie ist.

6. Vorrichtung nach einem der Ansprüche 1 bis 5, dadurch **gekennzeichnet,** daß die Zwischenräume (1-11,1-12) so ausgerichtet werden können, daß sie genau gleich sind und diese Ausrichtung stabil über lange Zeitspannen beibehalten.

FIG 1

FIG 2

FIG 3

EP 0 257 184 B1

*FIG 4*